(19) Europäisches Patentamt
European Patent Office
Office européen des brevets

(11) Publication number: 0 048 160
B1

(12) EUROPEAN PATENT SPECIFICATION

(45) Date of publication of patent specification: 24.07.85

(51) Int. Cl.$^4$: G 03 C 5/48, G 03 F 7/26, G 03 C 1/00

(21) Application number: 81304217.3

(22) Date of filing: 15.09.81

# (54) Photosensitive recording material, and method of half-tone etching.

(30) Priority: 15.09.80 US 187623

(43) Date of publication of application: 24.03.82 Bulletin 82/12

(45) Publication of the grant of the patent: 24.07.85 Bulletin 85/30

(84) Designated Contracting States: AT BE CH DE FR GB IT LI LU NL SE

(56) References cited: None

(73) Proprietor: NAPP SYSTEMS (USA) INC.
360 South Pacific P.O. Box 246
San Marcos, CA 92069 (US)

(72) Inventor: Hallman, Robert W.
16458 Bronco Lane
Poway California 92064 (US)
Inventor: Langlais, Eugene L.
17619 Cabela Drive
San Diego California 92127 (US)
Inventor: Bohannon, Ronald G.
2424, N. Tustin S-S
Santa Ana California 92705 (US)
Inventor: Rubic, Dominic B.
4076 Thomas Street
Oceanside California 92054 (US)

(74) Representative: Spencer, Graham Easdale
A.A. Thornton & CO Northumberland House
303-306, High Holborn
London WC1V 7LE (GB)

EP 0 048 160 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates generally to photosensitive recording and half-tone etching of recording materials.

Probably the most commonly used photosensitive recording materials employ silver halide based compositions. Silver halide contact films, for example, have been widely used for many years and are still the standard of the industry. Similarly, a wide variety of silver halide colour proofing films and contact papers are in common use. Even printed circuit resists generally rely on silver halide based photosensitive systems.

Silver halide photosensitive recording compositions are inconvenient to store and to use. They must be stored in light-tight containers. Their shelf life is very limited. Furthermore, processing must be carried out in the dark or under subdued, safelight conditions. Development of silver halide based compositions is generally a multi-step process requiring separate development, fixing and washing procedures. The chemicals used in these procedures are also ecologically undesirable, being often toxic and difficult to dispose of. Furthermore, even after processing, the resulting images deteriorate quickly and are readily scratched and otherwise susceptible to surface damage.

Silver halide films pose further difficulties when attempting to produce halftone images. For example, the production of halftone images of uniform optical density is quite difficult, particularly in those applications where it is further necessary to reduce image surface area by etching image dots and holes.

Silver halide imaging compositions offer very limited etching latitude. When the silver halide image is subjected to an etching solution, the solution attacks the perimeter of the image (dots in highlight areas, holes in shadow areas) and the top surface of the image as well. Thus, the thickness of the image is reduced along with its perimeter resulting in an image of reduced optical density. Since significant reductions in optical density are generally unacceptable in many applications (e.g. color proofing), only very limited etching of silver halide halftone images is possible. Furthermore, similar problems arise in non-silver halide based images where the image surface is unprotected from the etching solution.

Although alternatives to silver halide photosensitive imaging compositions have been proposed and are now offered in the marketplace, these alternative materials have not significantly displaced the silver halide materials for a number of reasons. For example, these alternative materials suffer many of the same disadvantages found in the silver halide materials, including storage difficulties, short shelf life, safelight and multi-step development, and ecologically undesirable processing procedures. These alternative compositions are also succeptible to scratching and other damage, both before exposure and development and after. As a result, post-development protective overcoats are often necessary. Furthermore, unlike the silver halide compositions, these alternative compositions often require multi-step exposures. Finally, and perhaps most importantly, these alternative materials usually have very limited development and exposure latitude and produce images of inadequate optical density and definition.

The present invention is concerned with photosensitive recording materials consisting of a substrate, an image layer disposed upon the substrate and a photosensitive resist layer disposed upon the image layer. According to the present invention, the resist layer has a thickness of 0.5 to 2.0 micrometres, and the image layer has a thickness of from 0.3 to 3.0 micrometres and comprises a copolymer of molecular weight of 1000 to 150000 of the following formula:

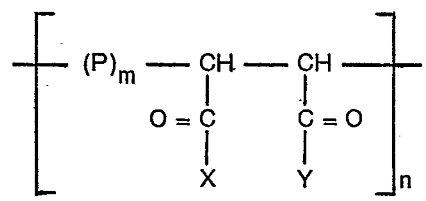

in which P is units of styrene, ethylene or methyl vinyl ether, X is —OH, $—ONH_4$, —ONa, —OK, —OLi, —OR, $—ONH_3R$, $—ONH_2R_2$, $—ONHR_3$, or $—ONH_3RNH_2$, in which R is an optionally substituted alkyl group, Y is any group that X may be, or X and Y together represent —O—, m is 1 to 13 and n is 1 to 10.

The recording material according to the invention does not require special handling, multiple step exposure or development and may be stored and developed under daylight conditions, may be readily processed with water or mildly alkaline developer solutions to produce durable images, and can produce images with outstanding definition and optical density which furthermore are durable, long lasting and reasonably resistant to scratching and other surface damage even without a protective overcoating.

The recording material according to the invention can produce high quality half-tone images that may be readily etched to varying degrees without significantly affecting image optical density. The image layer must be soluble in a given developer and comprises the copolymer indicated above. The copolymer is preferably chosen from a particular group of styrene-maleic anhydride (SMA) copolymers, which will be described in further detail below. Within this group of copolymers, a particularly important subgroup is bimodal styrene-maleic anhydride copolymers, which will also be described in detail below. These bimodal copolymers preferably comprise a combination of high molecular weight and low molecular weight polymer portions in a weight ratio of 2:8 to 8:2, more preferably about 2:3 to 3:2, typically 5:5. When such

bimodal copolymers are used, the low molecular weight portion preferably has a molecular weight of less than 5,000 and the high molecular weight portion preferably has a molecular weight exceeding 10,000. Preferred low molecular weights lie in the range of 1,000—2,000, and a preferred high molecular weight is in the range of 10,000—150,000, most preferably in the range of 20,000—50,000.

The resist layer generally consists of an organic-based material whose solubility with respect to a given developer changes upon exposure of the resist layer to actinic electromagnetic radiation. Particular suitable resist materials will be described below.

Preferred embodiments of the present invention will now be described, with reference to Figures 1 to 6 of the accompanying drawings, in which:

Figure 1 is a cross-section illustrating a photosensitive recording material of the present invention as conventionally exposed to electromagnetic actinic radiation through a half-tone screen;

Figure 2 is an illustration of the material of Figure 1 after exposure through the half-tone screen showing the formation of a latent image in the resist layer;

Figure 3 is an illustration of the material of Figure 2 after removal of unexposed portions of the resist layer and corresponding portions of the image layer to leave a half-tone highlight (dot) image on the substrate;

Figure 4 is a representation, in section, of the half-tone image of Figure 3 after etching of the pigmented image layer;

Figure 5 is a top view of the etched material of Figure 4;

Figure 6 is a top view similar to that of Figure 5 showing an etched half-tone shadow (hole) image produced with a photosensitive recording material according to the present invention.

Similar reference numerals are applied to corresponding features throughout.

With brief reference to the drawings, a photosensitive recording material 10 is illustrated in Figure 1 including a substrate 12, an image layer 14 (containing a colourant) and a resist layer 16. Above the resist layer 16 is a half-tone screen 18 positioned for image-wise exposure of the material.

The substrate in the recording material according to the present invention may be clear, as in the case of clear plastics film or glass; it may be opaque, as in the case of papers or metal plates and foils; or it may be translucent, as in the case of matte films. Useful substrates include clear polyethylene, polyethylene terephthalate and polycarbonate films, such as thermoplastic polycarbonate condensation products of bisphenol-A and phosgene (such as the material available under the Trade Mark Lexan). Such clear films can be used to produce photosensitive recording materials such as general purpose contact films and colour proofing films. Useful opaque substrates include papers of various kinds, such as filled polypropylene synthetic papers and polyethylene coated cellulose papers. Also tinted opaque substrates can be used to produce print papers, as well as negative and/or positive proofing papers.

Since the present photosensitive recording materials may be used to produce lithographic plates, useful lithographic substrates include metal plates and other rigid supports (having an abraded surface). Finally, useful translucent substrates include matte polyethylene, polyethylene terephthalate and polycarbonate films, which are matted during their manufacture or with subsequently applied coatings. The recording materials produced with these substrates can be used as, for example, engineering drawing intermediates suitable for diazo-type white prints, sepias, and for other purposes.

The image layer used in the recording material according to the present invention should be of a composition soluble in a developer for the particular resist layer employed. Developers particularly useful in the practice of the present invention include water and mild aqueous alkaline solutions. These developers will be discussed further in connection with the resist layers and in the Examples set forth below.

Many of the important advantages obtained with the recording material of the present invention are the result of careful control of the thicknesses of the image and resist layers.

Turning first to the image layer, it has been found that the thickness of this layer should be within the range of 0.3 to 3.0 micrometres, because thicker image layers results in slow and difficult development, as well as poor resolution, while image layers thinner than 0.3 micrometres generally lack the requisite film strength and adhersion, and cannot produce optical density for contact papers and colour proofing films.

Within the specified thickness range for the image layer, it has been found that for certain applications there are preferred thickness ranges. Thus, for example, optimal colour proofing films require image layers of from 0.3 to 1.0 micrometre in thickness. This produces optimal colour intensity and purity, as well as outstanding resolution. General purpose contact films, on the other hand, should optimally have image layers in the broader thickness range of 1.0 to 3.0 micrometres.

As indicated above, the image layer preferably comprises a styrene-maleic anhydride copolymer; certain such polymers exhibit unexpectedly superior performance and are readily tailorable to specific applications, such as the production of photosensitive recording materials suitable for halftone image formation and etching.

The styrene-maleic anhydride (SMA) copolymers found to be particularly useful in the present invention include those having a molecular weight in the range of 1,000 to 150,000 of the following formulae:

1. SMA copolymers

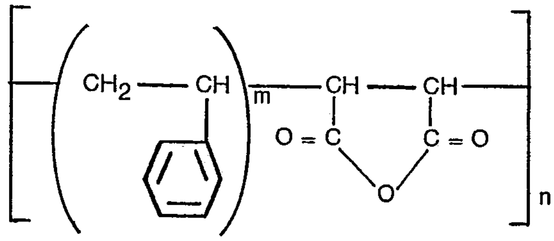

where m=1—3, n=1—10

2. Half esters and ammonium half amides of SMA copolymer

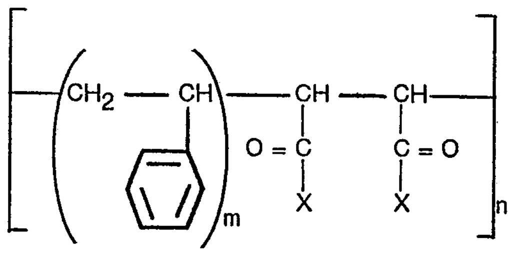

where X is OH, $ONH_4$, OR, $ONH_3R$, $ONH_2R_2$, $ONHR_3$, ONa, OK, OLi, R is a 1—10 C alkyl group, optionally including a functional group such as ketone, alcohol, ether, ether alcohol, or aryl and m=1—3, n=1—10.

Useful additives which may be blended with the such polymers include film-forming polymers also of molecular weight in the range 1,000—150,000 of the following formulae:

3.

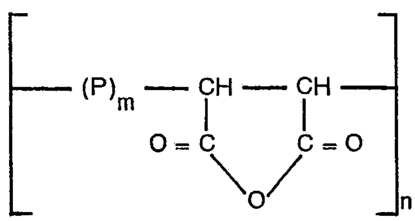

4.

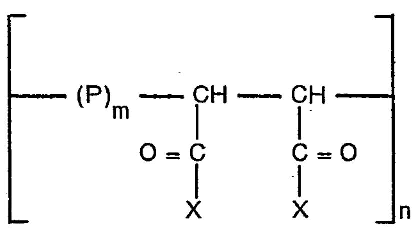

where X, m, and n are as described in connection with formulae 1 and 2 above and P is ethylene or methylvinyl ether.

In some applications it may be desirable to tailor the characteristics of the above-described polymers. For example, since higher molecular weight polymers tend to be less soluble in aqueous developers, it may be necessary to introduce additives to improve image layer solubility. Low molecular weight polymers of the above-described structures may be used in such cases to improve solubility. For example, a SMA copolymer based on formula 1., where m=1—3, n=6—8 and molecular weight of 1500—3000, as well as half esters and amine salts thereof, are particularly useful in increasing image layer solubility. Other useful solubilizing agents would include generally linear ethylene-maleic anhydride copolymers having a molecular weight between 8000 and 10,000, as well as their acid, single ammonium salt, double ammonium salt, half ester and diester forms. Another useful class would be poly(methylvinylether)-maleic anhydride copolymers and their corresponding half ester forms, of molecular weight 5000—100,000. Yet another class of water-soluble materials useful in this connection would be glycols.

In addition to such solubilizing agents, film modifiers may be included in the image layer. For example, polyvinylacetate may be used to improve image layer flexibility and epoxy esters can be used to improve abrasion resistance.

The image layer 14 may be applied to the substrate 12 by conventional coating techniques; for example, solvent or aqueous casting techniques may be employed, as well as conventional roller and gravure application procedures.

Adhesion can present a problem when applying a thin coating to a substrate as in the present

invention. This problem may be overcome by selection of image layer and substrate materials which exhibit a good adhesive compatibility. In other cases, as where polyethylene and polyethylene terephthalate films are used, it may be necessary to apply a subcoating to the substrate or to use specially pre-treated substrates. For example, where the image layer is aqueous cast, it may be particularly helpful to subcoat the substrate with a high molecular weight SMA copolymer (average molecular weight approximately 50,000) in methyl ethyl ketone. With solvent cast films, similar subcoating with high molecular weight SMA copolymer may also prove helpful. The use of such a sublayer has a further unexpected advantage for both aqueous and solvent castings in that the resultant recording material can produce clearer backgrounds due to the absence of pigment retention on (or staining of) the substrate. A less preferred alternative is to use pre-treated films carrying an adhesive coating to improve image layer adhesion to the substrate.

In applications such as photosensitive recording materials for use as lithographic plates, it is not necessary to introduce a colouring medium into the image layer. However, in a preferred embodiment of the present invention, the image layer will contain a colorant uniformly dispersed within the film-forming vehicle.

The colorant may be a commercially available pigment or dye, and used in aqueous form, in solvent-soluble form, or in the form of a dispersion. Where a particulate material is used, the particle size must be less than the image layer thickness. Preferably, the particulate colorant has particles of size 10 to 500 nm, more preferably in the range of 25 to 250 nm. Generally, smaller particle sizes give better coverage, opacity, and film strength. The quantity of colorant used should be sufficient to produce an optical density in the recording material of at least 3.0.

According to another aspect of the present invention, therefore, there is provided a photosensitive recording material which comprises a substrate having thereon, in the order specified, an image layer of thickness 0.3 to 3.0 micrometres comprising a film-forming vehicle and a colorant uniformly dispersed therein in an amount sufficient to provide an optical density of at least 3.0, and a photosensitive resist layer of thickness 0.5 to 2.0 micrometres.

On a weight basis, the ratio of colorant to film-forming vehicle is in the range of 9:1 to 1:1 and preferably in the range of 2:1 to 1:1. The amount of pigment actually used will depend upon the intended application, since colorant to vehicle ratios affect many film characteristics such as adhesion, flexibility and development speed.

Typical pigments and dyes useful in the present invention are listed in Tables A and B below.

TABLE A Pigments

| | |
|---|---|
| Titanium Dioxide (rutile form) | Quinacridone Violet 19 |
| Zinc Oxide | Phthalo cyanine Blue |
| Iron Oxides (natural) | Carbon Black |
| Chrome Oxide Green | Raven 1000R |
| Molybdate Orange | Regal 400R, 300 |
| Ultra Marine Blue | Elftex 8 |
| Hansa Yellow G | Special Schwarz 4A |
| Toluidine Red | Mogul A |
| Lithol Red | Monarch 74 |
| Lithol Rubine | Aqua Black Dipersion |
| Diarylide Yellow | Auresperse W7012 |

TABLE B Dyes

| | |
|---|---|
| Methyl violet | Victoria Blue B |
| Rhodamine B | Malachite Green |
| Fuchsine | Bismark Brown R |
| Methylene Blue | Alizarine Orange |

The resist layer 16 may be applied to the image layer again using conventional coating techniques. The thickness of this layer is generally from 0.5 μm to 2.0 μm, in order to obtain outstanding exposure, development and resolution characteristics. (Resist layers of thickness below 0.5 μm are generally of insufficient resist strength and adhesion, and display poor scratch resistance, while too thick resist layers result in poor resolution and poor shelf life; thick resist layers also require increased development time and are generally uneconomic).

The resist layer consists of a material whose solubility with respect to a given developer is changed upon exposure to actinic radiation.

The resist material may be negative-working (soluble in developer prior to exposure and rendered insoluble on exposure to actinic radiation) or positive-working (insoluble in developer prior to exposure and rendered soluble on exposure and rendered soluble on exposure to actinic radiation).

While a great variety of such materials are well known in the art, the outstanding advantages of the present invention may best be obtained with a resist material of the type described and claimed in British Specification 1548764. The latter specification discloses a resist material comprising a generally continuous

phase and a generally discontinuous phase, with the continuous phase being a minor constituent by weight of the overall structure. The continuous phase consists of a photosensitive material whose solubility with respect to a developer is changed upon exposure to actinic radiation. The discontinuous phase which is a major constituent by weight of the overall structure consists of a polymeric emulsion-dispersion made up of a particulate material which is substantially insoluble in the developer. The two phases are uniformly interdispersed throughout the entire resist layer 16. The reader is directed to the above British Specification for a fuller disclosure of this preferred type of resist material.

The minor phase material of the above resist composition may be selected from diazo compounds, photopolymers, light sensitive dyestuffs, azo compounds, and dichromates. The polymeric major phase material of the emulsion-dispersion of the resist film may be selected from polyacrylics, copolymers of acetate and ethylene, copolymers of styrene and acrylates, polyvinyl acetates and copolymers of vinyl acetate and acrylates.

Preferred compositions of the above described continuous phase-discontinuous phase resist layer may be formed from a polyvinyl acetate-acrylic polymer emulsion dispersion in water with para-diazo diphenylamine sulphate condensation product with paraformaldehyde (stabilized with zinc chloride). Preferred alternative discontinuous phase materials include polyacrylamide, polyvinyl acetate, polystyrene allyl alcohol and polyvinyl butyral.

Other photosensitive materials useful as resists in the present invention include aqueous based diazo/colloid mixtures such as: para-diazo diphenylamine sulphate condensation product/hydroxy ethyl cellulose (such as Natrosol HHR 250 from Hercules) or para-diazo diphenylamine sulphate condensation product/polyacrylamide (high molecular weight).

Useful solvent based alternative resist materials would include mixtures of solvent soluble diazos and resins. Such diazos are typified by those listed in Table C. The resins useful in such cases are typified by those found in Table D. These tables, however, should not be considered restrictive.

TABLE C

1.) Sulfoesters of napthaquinone 1, 2 diazides such as:

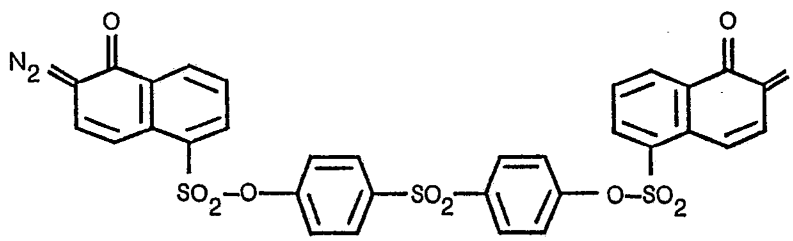

2.) Sulfonamides of naphaquinone 1, 2 diazides such as:

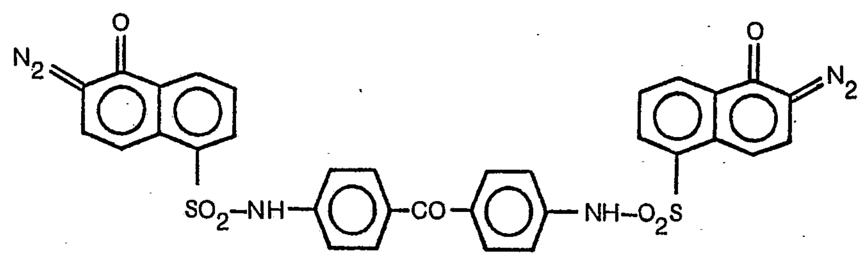

3.) Reaction products of paradiazo diphenylamine sulfate—formaldehyde resins with: phosphotungstic acid, phospomolybdic acid, tetrafluoroboric acid, hexafluorophosphoric acid, toluene sulfonic acid, napthalene 1,5 disulfonic acid, vinyl phosphonic acid, 2,2',4,4' tetrahydroxy benzophenone.

TABLE D

| | |
|---|---|
| Phenolformaldehyde novalak | Poly amide resins |
| m-cresol formaldehyde novalak | Phenolic resins |
| Epoxy resin (epichlorohydrin-bisphenol A) | Phenoxy resins |
| Poly vinyl acetate | Epoxy ester resins |
| Poly vinyl butyral | Polyimide resins |
| Ethyl acrylate-acrylic acid polymer | Vinylidene-acrylonitrile copolymer |
| Vinyl acetate-vinyl phthalate copolymer | |

A post-exposure treatment solution or developer particularly preferred for use in connection with the above-described diazo materials is disclosed in PCT Specification WO 79/00593. The treatment solution described therein includes a water-soluble desensitizing agent capable of reacting with residual photosensitive diazo to render it incapable of forming an oleophillic substance, and a filming agent selected from water-soluble aliphatic polyols having less than eight carbon units, the acid derived

monoesters of these polyols, and the alkaline metal salts of the monoesters. The reader is directed to the above PCT specification for a fuller disclosure of this preferred type of treatment.

The photosensitive recording materials of the present invention may be formed by conventional methods. The image layer is first coated onto the substrate, optionally in successive passes, and followed by the resist layer which may be also applied in successive passes. The layers may be cast from solvents or from aqueous media, depending upon the choice of resist material and image layer film-forming vehicle. It is, of course, necessary, in most instances, that the image layer first be dried before the resist layer is applied and itself dried. Particular drying temperature requirements will depend upon the nature of formulations being used and will be apparent to those skilled in the art.

Exposure of the photosensitive imaging articles of the present invention will depend upon the thicknesses and composition of the resist and image layers. For colour proofing films, for example, exposures of 10—30 seconds under a five kilowatt mercury vapour source (2800 microwatt/cm$^2$) will produce satisfactory images. For lithographic films, 20—180 seconds under a similar source will suffice while 30—60 seconds are preferred.

As those skilled in the art would expect, development time is directly related to the thickness of the resist and image layers, as well as to the colorant to vehicle ratio, polymer molecular weight, polymer acid value, developer strength (e.g., concentration, pH, surface tension, ionic components) and thermal treatment history of the image layer. Generally development times will range from 15—120 seconds while 30—90 seconds are preferred. For positive working resists, where the positive working resist material is rendered soluble upon exposure, exposure time is, of course, a more significant factor in determining the development time.

As indicated above, preferred recording materials according to the invention are used for halftone applications.

Halftone images actually comprise an array of tiny dots in highlight areas and an array of tiny holes in shadow area. The halftone image is, produced by exposing a photosensitive recording material, such as a proofing film, to actinic radiation through a halftone screen as illustrated in Figure 2. In this figure, the recording material comprises a substrate 12, pigmented image layer 14 and negative-working resist. After exposure, a latent image consisting of exposed portion 20 (which has been rendered insoluble to a given solvent) and unexposed portion 22 (whose solubility with respect to the same solvent unaltered) is formed. Upon development, which is carried out by contacting and optionally rubbing the requisite developer over the surface of the recording material, the resist soluble portion 22 is removed along with corresponding soluble portion of the image layer 14. This leaves the structure depicted in Figure 3, wherein dots 23 are shown in cross-section. These dots have an optical density predetermined by the optical density of the image layer 24, which is in turn a function of layer thickness, the concentration and the nature of the coloring medium dispersed or dissolved therein, and the method of dispersion employed.

In color proofing and in other halftone applications, it is generally desirable and often required that the halftone images be etchable. The purpose of the etching process is to reduce the size or cross-sectional area of the dots in highlight areas and to increase the size of the holes in shadow areas to correct color and tone reproduction. It is most important in these applications that the optical density of the dots and the areas surrounding holes remain generally unaltered by the etching process.

As explained earlier, prior art films used as color separations cannot be etched without affecting dot/hole image optical density and possibly causing pinholing, because etching solutions attack both image surfaces as well as image perimeters. This shortcoming of prior art materials may be overcome to a very limited extent by using exposures that produce excessively thick dots, so percentagewise, loss of density upon etching is minimized. In this case, as well as in the general case where normal dots are produced, there is, however, always some danger of pinholing and some loss of optical density. When the optical density loss is excessive, the master is rendered useless, since actinic radiation can "burn through" areas of reduced density. Even without excessive density reduction, however, the change of optical density on the film limits film exposure latitude.

In contrast with prior art halftone systems, the novel structure of the present invention will undergo, upon etching, a reduction in dot diameter and an increase in hole diameter without significantly affecting optical density. Thus, it is seen from Figure 3 that the dot resist portion will protect the surface 15 of the dot image layer 24 from the etching solution, and from scratching and other surface damage. When the dot image of Figure 3 is subjected to further development or etching using a developer of generally equal or greater strength than that originally used, portions of the perimeters of the dot image layers 24 are removed decreasing the diameter from $d_1$ to $d_2$ without altering the thickness or density of that layer. The actual dot structure is illustrated in Figure 4, in which the resist dot portion 20 is unchanged but the dot image layer 24' is significantly reduced in cross section. A top view of the dot images of Figure 4 appears in Figure 5. In connection with the etched dot structure of Figure 4, it should be further noted that the unsupported edges of the resist layer will tend to fall, thereby protecting the perimeter of the half-tone images from damage due to abrasion and contact with foreign substances.

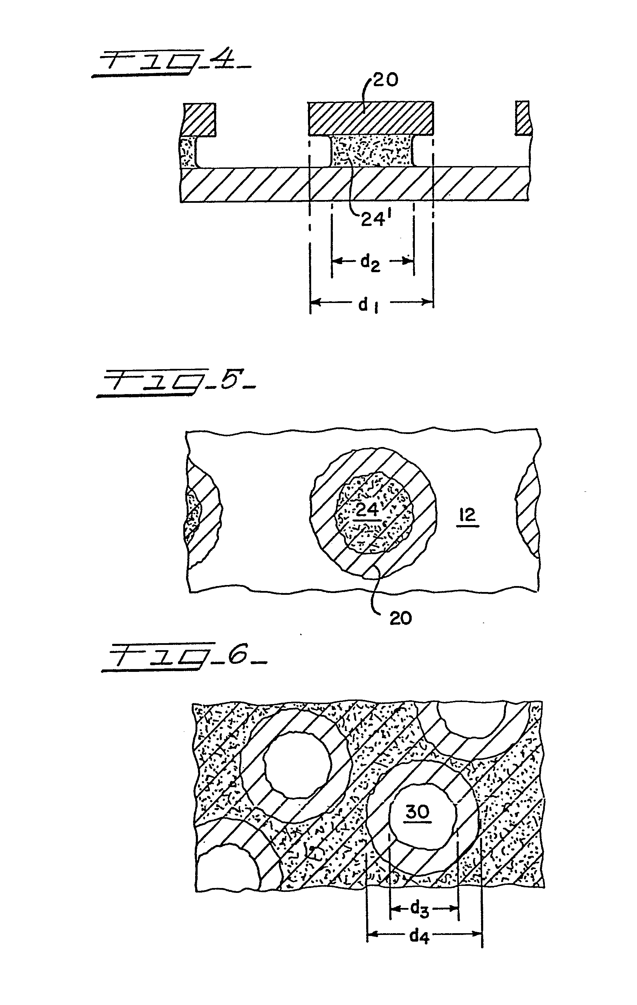

Likewise, Figure 6 illustrates a shadow area of a halftone image, after exposure and etching, the holes 30 having been enlarged from diameter $d_3$ to diameter $d_4$ by the etching procedure while the resist layer remains unchanged by etching. The photosensitive recording material according to the present invention provides good exposure and development latitude, accompanied by good dot etchability. Good exposure

and development latitude require that the image layer should have a film-forming vehicle which is not too soluble in the developer (or else background areas would be totally cleaned and highlight areas lost before shadow areas are adequately developed). Referring to Figure 3, a too soluble image layer would mean that even a slight increase in the optimal development time would result in unsatisfactory reproduction, possibly unduly reducing the size of the dot 23.

While good development latitude requires that image layer 14 is not too soluble in the developer, good dot etchability requires just the opposite. That is, if dot image layer 24 is not sufficiently soluble in the developer, it will take too long to obtain the reduced dot image layer 24 of Figure 4.

The recording material according to the invention balances the conflicting requirements of development latitude and dot etchability.

In order that the present invention may be more fully understood, the following Examples, in which all parts are by weight, unless otherwise indicated, are given by way of illustration only.

Example 1

A photosensitive recording material according to the invention, useful as a general purpose contact film, may be prepared as follows. A 0.7 mm (4 mil) polyester sheet is subcoated with a 10% solution of SMA of average molecular weight 50,000 in ethylene glycol monomethyl ether, and then dried. The subcoated polyeseter sheet is then coated with an image layer 1.5—2.3 μm in thickness of the formula:

| | |
|---|---|
| 50 grams | SMA (average molecular weight 20,000) |
| 40 grams | Carbon black (Raven 1,000R) |
| 400 grams | N-butanol (as solvent) |

The image layer is then top coated with a photodispersion following the teachings of the above reference British Specification 1548764.

| | |
|---|---|
| 50 grams | Polyvinyl acetate—acrylic copolymer emulsion dispersion in water |
| 55 grams | Water |
| 2 grams | Paradiazo diphenylamine sulphate condensation product with para formaldehyde stabilized with zinc chloride (hereinafter referred to as diazo resin) |

This final coating has a thickness of 0.7—1.5 μm and the overall product thus produced is again subjected to drying to provide a final bi-layer, general purpose contact film.

The above film is then exposed through an appropriate mask to ultraviolet radiation from a high intensity source such as a 5 kilowatt mercury halide lamp. The bi-layer film is then developed in an aqueous solution of a mild alkaline material such as $Na_2HPO_4$ with a pH of about 9.5—10.5. Light mechanical action will help to accelerate development. Development results in the removal of unexposed areas of the resist layer and corresponding portions of the image layer. After a suitable development time of from 15—60 seconds, a final product is obtained consisting of the exposed portions of the resist layer and corresponding portions of the image layer, both on the polyester sheet substrate. If the original mask was a negative mask, the resulting bi-layer film image will be a positive image. If the original mask was a positive mask, the resulting bi-layer image will be a negative image.

The image area of the bi-layer film made in accordance with this example will have an optical density in transmission of about 3.3—4.2. Since carbon black absorbs radiation in a wide range of wave lengths, this composition will be useful not only as a general purpose contact film, but also as a master for color proofing films, litho plates, and in circuit board manufacture. The resolution obtainable with this composition is at least 60 lines per cm (150 lines per inch).

Example 2

A photosensitive recording material utilizing an image layer with a bimodal organic film-forming vehicle may be produced as follows. The subcoated polyester substrate of Example 1 is coated with a pigment base layer having a thickness of 2.0 μm and the formula:

| | |
|---|---|
| 60 grams | Carbon Black |
| 60 grams | SMA (average molecular weight 20,000) |
| 30 grams | SMA (average molecular weight 2,000) |
| 600 grams | n-butanol, as solvent |

After this image layer is dried, a resist layer of 1.0 μm in thickness and the following formula is applied:

| | |
|---|---|
| 50 grams | Polyvinyl acetate-acrylic copolymer emulsion dispersion in water |
| 4 grams | Diazo resin |
| 60 grams | Water |

The bi-layer imaging article thus produced is exposed and developed as in Example 1. A negative master is used so that a positive print is obtained. Since exposure is carried out through a half tone screen, the image on the bi-layer film is made up of an array of dots in highlight areas and holes in shadow areas.

latitude. The most preferred balance of density latitude, resolution and development speed are obtained with films having image layers of from 1.5 to 2.5 µm in thickness.

Example 6

The Example 2 structure was made with the exception that the high molecular weight SMA was replaced with a somewhat lower molecular weight species. The actual composition of the image layer was:

| | |
|---|---|
| 70 grams | SMA (molecular weight 10,000) |
| 40 grams | SMA (molecular weight 2,000) |
| 60 grams | Carbon black |
| 600 grams | n-butanol |

The photosensitive recording material obtained exhibited a faster development speed than that of Example 2 while maintaining acceptable development latitude and dot etching speed.

Example 7

The effects of the molecular weights of the copolymers making up the film-forming vehicle of the image layer were evaluated in another two photosensitive recording materials prepared in accordance with the Example 2 teaching. These two films had image layers containing respectively:

| | | |
|---|---|---|
| 1. | 10 grams | SMA (molecular weight 50,000) |
| | 40 grams | SMA (molecular weight 10,000) |
| | 75 grams | Carbon black |
| | 650 grams | n-butanol |
| 2. | 25 grams | SMA (molecular weight 50,000) |
| | 60 grams | SMA (molecular weight 20,000) |
| | 65 grams | Carbon black |
| | 600 grams | n-butanol |

Both of the above image layer compositions were found to produce useful films, in terms of mechanical strength. However, in both cases the dot etchability of the films was unsatisfactory for practical applications.

Example 8

In this example, alternative polymers were substituted for the SMA of Examples 1 and 2. The particular formulae used to produce these image layers were the following:

| | | |
|---|---|---|
| 1. | 80 grams | Poly(methyl, vinyl, ether/maleic acid) isopropyl mono ester (Gantrez 335) Gantrez is a Trade Mark) |
| | 70 grams | Carbon black (Regal 330R) |
| | 700 grams | n-butanol |
| 2. | 80 grams | Poly(methyl, vinyl, ether/maleic acid) butyl mono ester (Gantrez 425) |
| | 70 grams | Carbon black |
| | 700 grams | n-butanol |
| 3. | 40 grams | Poly(methyl, vinyl, ether/maleic acid) butyl mono ester |
| | 50 grams | SMA (molecular weight 10,000) |
| | 300 grams | n-butanol |
| | 400 grams | Ethylene glycol monomethyl ether |

In cases 1 and 2, the mechanical strength of the resulting film was generally unsatisfactory. In the case of formulation 3, however, far improved mechanical strength accompanied by other desirable film properties was obtained.

Example 9

The teachings of Example 2 were followed, but alternative subcoatings of the following formulation were used:

| | | |
|---|---|---|
| 1. | 1 gram | SMA (molecular weight 50,000) |
| | 9 grams | Carboxylated polyvinyl acetate (Nivac ASB 516—Air Products) |
| | 100 grams | Ethylene glycol mono methyl ether |

The color or tone of the halftone images may be adjusted by subjecting the bi-layer film to treatment with an alkaline etching solution like that used in development. A typical etching solution would be a $Na_2HPO_4/Na_3PO_4$in water to produce a pH of about 11—12. This "dot etching" of the image is successful and produces the desired reduction in color and tone, without significantly affecting the optical density of the image dots and the portions of the image surrounding shadow holes.

Example 3

The procedures of Examples 1 and 2 were followed to produce a series of six different bi-layer photosensitive recording materials with organic film-forming vehicles of varying ratios of high and low molecular weight polymer. These films were then tested to evaluate their development speed, development latitude and dot etching speed. For present purposes, "development speed" means the time required to remove soluble portions of the resist and corresponding portions of the image layer to produce a satisfactory image on the film substrate. "Development latitude" refers to the range of development time which permits the bi-layer film to have background areas totally cleaned and shadow areas opened while still maintaining highlight areas of the film image. Finally, "dot etching speed" refers to the minimum time required to obtain a 50% reduction in the surface area of highlight images (and a corresponding 30% increase in the area of the shadow images).

The various bi-layer films produced in this example and their respective properties are listed in the table below:

TABLE I

| | A | B | C | D | E | F |
|---|---|---|---|---|---|---|
| SMA (Molecular Weight 20,000) | 90 | 60 | 50 | 40 | 20 | 0 |
| SMA (Molecular Weight 2,000) | 0 | 30 | 40 | 50 | 80 | 90 |
| n-butanol | 600 | 600 | 600 | 600 | 600 | 600 |
| Carbon black (Raven 100R) | 60 | 60 | 60 | 60 | 60 | 60 |
| Development Speed (seconds) | 60 | 35 | 30 | 30 | 20 | 10 |
| Development Latitude | 1.3× | 2.5× | 2.8× | 2.7× | 1.8× | 1.2× |
| Dot Etching Speed (seconds) | 90 | 60 | 45 | 45 | 45 | 30 |

Examination of the above table will show that the compositions B, C and D display a combination of excellent development latitude and good dot etching speed. These examples utilize ratios of high molecular weight to low molecular weight polymer respectively of 60:30, 50:40 and 40:50. The results for composition E is less desirable though acceptable for some dot etching applications.

However, it is particularly interesting to examine compositions A and F which respectively utilize 100% of the high molecular weight polymer and 100% of the low molecular weight polymer. The composition A material has an extremely slow dot etching speed, making it ill suited to etching applications. The composition F material, on the other hand, has an extremely fast dot etching speed, but displays an undesirably narrow developing latitude. The extraordinary improvements in developing latitude and dot etching speed obtained in compositions B, C, D and E therefore represent an important, unexpected synergistic result.

Example 4

Recording materials are produced as set forth in Example 2, except the concentration of carbon black is varied from below 30 parts to over 90 parts.

Concentrations of carbon black within the range of 30 parts to 90 parts give good film structures. Below 30 parts, however, it is found that the thickness of the image layer must be increased greatly (e.g. from 1.5 μm to 4.0 μm) which produces an undesirable loss of resolution and development latitude. On the other hand, concentrations over about 90 parts increase film porosity resulting in overly rapid development, poor development latitude and a mechanically weak film. Furthermore, the increases over 90 parts carbon did not greatly improve the film optical density. The most preferred composition, based on development and dot etch speed, may be obtained with 60—79 parts carbon black.

Example 5

Recording materails for use as high optical density film masters are again produced as taught in Example 2 with the thickness of the image layer varied from 0.4—5.0 μm. Below about 1.0 μm the film obtained exhibits an undesirably low optical density, loss of mechanical strength and adhesion. On the other hand, films above about 3.0 μm in thickness exhibit significantly reduced resolution and density

| | | |
|---|---|---|
| 2. | 3 grams | SMA (molecular weight 20,000) |
| | 7 grams | Carboxylated polyvinyl acetate |
| | 100 grams | Methyl ethyl ketone |
| | 9 grams | SMA (molecular weight 50,000) |
| | 100 grams | Methyl ethyl ketone |

All of the above subcoatings exhibited good adhesion between the polyester substrate and the image layer and produced a film with good stability and development latitude.

In another variation, the subcoating was eliminated entirely and a pretreated polyester material, such as Celanar 4500 series polyester was used. Once again, the results were good. In yet another variation, the subcoating was again eliminated but an untreated polycarbonate film was used. And again, satisfactory adhesion was obtained.

Example 10

A series of formulations following the teaching of Example 2 were made with variations in the diazo resin of the resist layer. The resist layer formulations used in these alternative compositions were as follows:

| | | |
|---|---|---|
| 1. | 50 grams | Polyvinyl acetate—acrylic copolymer (PVAC) emulsion dispersion in water |
| | 6 grams | Diazo resin |
| | 100 grams | Water |
| 2. | 50 grams | PVAC emulsion |
| | 10 grams | Diazo resin |
| | 120 grams | Water |
| 3. | 50 grams | PVAC emulsion |
| | 15 grams | Diazo resin |
| | 130 grams | Water |
| 4. | 50 grams | PVAC emulsion |
| | 2 grams | Diazo resin |
| | 100 grams | Water |

All of the above formulations were found to be workable. The major differences between the formulations related to exposure time requirements. Resist layers of thicknesses between 0.75 and 1.5 μm gave optimal results. In addition, introduction of surfactants such as P-toluene sulfonic acid or the addition of thickening agents such as polyvinyl alcohol, or gelatin made it possible to obtain workable thicknesses up to about 2.0 μm, however, shelf life and resolution problems begin to arise at a thickness of about 2.0 μm.

Example 11

In this example, other water-soluble resins were added to the resist layer formulations top coated onto the structure of Example 2 to improve the performance of the overall recording material. Among the formulations were the following resist layers:

| | | |
|---|---|---|
| 1. | 50 grams | PVAC emulsion |
| | 10 grams | Diazo resin |
| | 120 grams | Water |
| | 1 grams | Hydroxy ethyl celullose |
| 2. | 50 grams | PVAC emulsion |
| | 10 grams | Diazo resin |
| | 120 grams | Water |
| | 2 grams | Polyvinyl alcohol (Monsanto PVA 20—90) |
| 3. | 50 grams | PVAC emulsion |
| | 10 grams | Diazo resin |
| | 130 grams | Water |
| | 2 grams | Gelatin |
| 4. | 50 grams | PVAC emulsion |
| | 10 grams | Diazo resin |
| | 130 grams | Water |
| | 1 gram | Water-soluble polyamide (K-resin from Unitika Ltd. of Japan) |

Each of the final photosensitive imaging films produced with the above resist layers showed improved shelf life, improved optical properties and enhanced developability.

The addition of water-soluble or dispersible resins may therefore be desirable in some instances in order to modify and improve performance and coating properties.

Example 12

Structures similar to those of Examples 1 and 2 were made with the use of the following solvent cast resist layers:

| | | |
|---|---|---|
| 1. | 10 grams | Diazo BBP (a P-diazo diphenylamine sulfate condensate with paraformaldehyde stabilized with hexa fluorophosphate) |
| | 100 grams | Dimethyl formamide |
| 2. | 10 grams | P-diazo diphenylamine sulfate condensate with paraformaldehyde stabilized with tetra fluoroborate (Diazo ZAL. BF 4 from Sobin Chemicals) |
| | 100 grams | Dimethyl formamide |

Both of these formulations produced films having superior shelf life and excellent resolution, especially in very thin films in the range of 0.2 to 0.6 μm.

Other organic solvents may be substituted for the dimethyl formamide without affecting the final characteristics of the film. For example, such solvents as dioxane, Dimethyl acetamide (DMAC), ethylene glycol monomethyl ether and methyl ethyl ketone (MEK) have been used satisfactorily.

Example 13

Resins were added to the resist layers described in Example 12 to determine whether film characteristics could thereby be enhanced. The following formulations were evaluated:

| | | |
|---|---|---|
| 1. | 60 grams | Diazo BBP |
| | 30 grams | SMA (molecular weight 20,000) |
| | 350 grams | Dimethyl acetamide (DMAC) |
| 2. | 50 grams | Diazo BBP |
| | 40 grams | SMA (molecular weight 50,000) |
| | 20 grams | SMA (molecular weight 2,000) |
| | 350 grams | DMAC |
| 3. | 55 grams | Diazo ZAL.BF4 |
| | 35 grams | Alkaline soluble polyvinyl acetate |
| | 200 grams | Dimethyl formamide |
| | 150 grams | n-butanol |
| 4. | 50 grams | Diazo ZAL.BF4 |
| | 30 grams | Polyvinyl butyral |
| 5. | 114 grams | Diazo BBP |
| | 75 grams | SMA (molecular weight 20,000) |
| | 21 grams | Polyvinyl acetate |
| | 78 grams | SMA (molecular weight 2,000) |
| | 900 grams | DMAC |
| 6. | 100 grams | Diazo BBP |
| | 30 grams | Polystyrene allyl alcohol |
| | 20 grams | Novolak 1280 |
| | 750 grams | DMF |
| 7. | 60 grams | Diazo BBP |
| | 30 grams | Phenolic resin (Hercules Vinsol 790224-B) |
| | 300 grams | DMF |

The results obtained in each case were good, the resin additions providing improved film formation and mechanical strength. Both alkaline soluble and non-alkaline soluble resins were useful, although alkaline soluble resins could be used in higher proportions. In fact, mixtures of alkaline soluble and non-soluble resins may, in certain instances, provide enhanced development latitude. In this connection, formulation 5 is a preferred embodiment.

In addition to the resins referred to in the above exemplary compositions, other useful resin additives are epoxies, phenoxies, acrylics, silicones, polyesters and polyamides.

| | | |
|---|---|---|
| 2. | 80 grams | Mogul carbon black |
| | 100 grams | SMA (molecular weight 10,000) |
| | 80 grams | Ethylene glycol mono methyl ether |
| 3. | 45 grams | Phthalocyanine blue |
| | 110 grams | SMA (molecular weight 20,000) |
| | 1,000 grams | n-butyl alcohol |
| 4. | 38 grams | Sun yellow AAA |
| | 90 grams | SMA (molecular weight 2,000) |
| | 850 grams | Ethylene glycol mono methyl ether |

The above compositions were used in the structures of Examples 1, 2, 12, 13 and 14 to produce useful overlay color proofing films.

Example 17

Image layer compositions following the teaching of Examples 1, 2, 12, 13, 14 and 16 could next be applied to white opaque substrates to produce negative and/or positive proofing or print papers. Suitable substrate materials would include filled polypropylene synthetic paper (e.g. Kimdura FPG 150, Melinex 990), and typical RC papers such as polyethylene coated cellulose papers. Further useful photosensitive imaging articles could be obtained by using the $TiO_2$ image layers suggested in Example 15 to coat paper pigmented black and overcoated with polyethylene.

Yet further useful photosensitive recording materials could be produced by coating the structure of Example 14 onto translucent substrates. These materials would be useful as engineering drawing intermediates such as masters for diazo-type white prints and sepias. Suitable translucent substrates for this application would include: matte polyethylene terphthalate (PET) films, matte coated PET films (typically with $SiO_2$ in a resin binder as the matte coating) and matte finished polypropylene films.

Example 18

While the image layers of the prior examples have been coated from solvent bases, aqueous base coating can also be accomplished within the teaching of the present invention. Such aqueous based coatings have a number of important advantages, since they are often times more economical, less toxic and more acceptable environmentally. Typical useful aqueous base image layer formulations include the following:

| | | |
|---|---|---|
| 1. | 20 grams | SMA (molecular weight 20,000; 10% solids solution in $NH_4OH$) |
| | 10 grams | 28% $NH_3$ |
| | 170 grams | Water |
| | 0.01 grams | Triton X-100 (nonionic surfactant) |
| | 70 grams | Predispersed carbon black (i.e. Aquablack 135 from Bordon Chemical) |
| 2. | 15 grams | SMA (molecular weight 20,000; 15% solution in $NH_3 \cdot H_2O$) |
| | 4 grams | 28% $NH_4OH$ |
| | 80 grams | $H_2O$ |
| | 40 grams | Predispersed carbon black |
| | 25 grams | SMA (molecular weight 2,000; neutralized with $NH_4OH$) |
| 3. | 18 grams | SMA (molecular weight 20,000; 15% solution in $NH_3 \cdot H_2O$) |
| | 108 grams | SMA (molecular weight 10,000; 10% solution in $NH_3 \cdot H_2O$) |
| | 36 grams | Predispersed carbon black |
| 4. | 20 grams | SMA (molecular weight 20,000; 15% solution in $NH_3 \cdot H_2O$) |
| | 80 grams | SMA (molecular weight 10,000; 10% solution in $NH_3 \cdot H_2O$) |
| | 30 grams | SMA (molecular weight 20,000; 10% solution in $NH_3 \cdot H_2O$) |
| | 1 gram | Triton X-100 (nonionic surfactant) |
| | 25 grams | Predispersed carbon black |

The above image layers can be coated onto all of the substrates discussed earlier and may, as well, be overcoated with each of the resists of the above examples. It is also important to note that the development rate and development latitude of bimodal compositions 2, 3 and 4 is far superior to the results obtainable with image layers having 100% of either a high or low molecular weight styrene maleic anhydride. Dot etchability for these formulations is also exceptional.

Example 19

As noted earlier, the photosensitive recording material according to the present invention can be developed with simple aqueous base developers. Organic solvents are not required. Furthermore, systems

Example 14

The structures of Examples 1 and 2 were made by using a positive resist in place of the negative working resists described earlier. Use of a positive working resist will, of course, produce a negative image from a negative mask and a positive image from a positive mask.

The particular positive working resist coat used in this example was:

| | |
|---|---|
| 30 grams | Quinone diazide (AZ 1350 J from Shipley) |
| 40 grams | Amyl acetate |

Development of the material bearing the above positive working resist was carried out in a developer consisting of:

| | |
|---|---|
| 75 ml | Developer AZ 606 (from Shipley) |
| 425 ml | Water (overall pH 11.5—12.5) |

Other useful developers for this resist would include the following compositions:

| | | |
|---|---|---|
| 1. | 4 grams | KOH |
| | 100 grams | Water |
| 2. | 10 grams | $Na_2CO_3$ |
| | 2 grams | $Na_3PO_4$ |
| | 100 grams | Water |
| 3. | 6 grams | $Na_3PO_4$ |
| | 1 gram | Sodium lauryl sulfate anionic surfactant |
| | 100 grams | Water |

Example 15

Test work with differing coloring media was carried out in this example. The image layer composition of Example 13 was replaced with the following pigmented composition:

| | | |
|---|---|---|
| 1. | 80 grams | SMA (molecular weight 20,000) |
| | 20 grams | SMA (molecular weight 2,000) |
| | 80 grams | Dinitraniline orange (pigment orange No. 5, 2,4-dinitroaniline coupled with beta naphthol) |
| | 400 grams | Ethylene glycol mono methyl ether |

Next the positive working structure of Example 14 was modified by replacing the image layer with the following alternate image layer compositions:

| | | |
|---|---|---|
| 2. | 80 grams | SMA (molecular weight 20,000) |
| | 20 grams | SMA (molecular weight 2,000) |
| | 80 grams | Dinitraniline orange (pigment orange No. 5 2,4-dinitroaniline coupled with beta naphthol) |
| | 400 grams | Ethylene glycol mono methyl ether |
| 3. | 100 grams | SMA (molecular weight 20,000) |
| | 90 grams | $TiO_2$ |
| | 500 grams | n-butanol |

Each of the above compositions produced a film with good ultraviolet absorbing characteristics. The white image produced with the film of composition 3 was of particular interest in duplicating negative masters. This film behaved like a negative but produced a positive image when viewed against a dark background. This unusual feature will be of particular use in the arts of proofing and stripping films.

Example 16

A number of overlay color proofing films were made with image layers having the following exemplary compositions:

| | | |
|---|---|---|
| 1. | 29 grams | Lithol rubine |
| | 110 grams | SMA (molecular weight 20,000) |
| | 850 grams | Ethylene glycol monobutyl ether |

can be formulated such that all of the products can be developed with the same developer. Alternatively, the formulations can be optimized for each resist using slightly different developers for the different resists such as in the case of the positive resist.

This aqueous, tailorable feature of the present invention permits a hitherto unimaginable variety of graphic arts articles to be developed by the same chemistry and in the same type of processing equipment. The problems associated with prior full-line contact speed graphic arts products employing silver halides, photopolymer, diazo-type, diazo resin and other technologies to produce a variety of films, papers, proofs, intermediates and lithographic printing plates can be eliminated. With these prior systems, the user was confronted with a bewildering array of supplies and equipment associated with each of these different technologies and their differing development chemicals and processing equipment requirements. In sharp contrast to these prior systems, however, the photosensitive imaging article of the present invention may use a single type of exposure source, as well as a single development chemistry and one type of process equipment.

Typical general application developers useful with the present photosensitive recording materials include:

| | | |
|---|---|---|
| 1. | 2% solution | Sodium metasilicate |
| | 1% solution | Sodium lauryl sulfate |
| 2. | 5 grams | $Na_2HPO_4$ |
| | 2 grams | $Na_3PO_4$ |
| | 100 grams | Water |
| 3. | 10 grams | $Na_2CO_3$ |
| | 25 grams | Sodium tripolyphosphate |
| | 1 gram | Sodium lauryl sulfate |
| | 100 grams | Water |
| 4. | 3 grams | KOH |
| | 1 gram | Triton X-100 |
| | 100 grams | $H_2O$ |
| 5. | 5% solution | Sodium lauryl sulfate |
| | 5% solution | Sodium sulfate |
| | 1% solution | Sodium xylene sulfonate |
| | 1% solution | $Na_3PO_4$ |

A particularly useful developing solution for use with the photosensitive recording materials of the present invention is disclosed in the aforementioned PCT, patent application Specification No. WO 79/00593. Typical useful formulations for this developer include:

| | | |
|---|---|---|
| 6. | 25 grams | Potassium toluene sulfonate |
| | 10 grams | Disodium beta-glycero phosphate |
| | 1 gram | Triton X-100 |
| | 100 grams | Water |
| 7. | 30 grams | Potassium toluene sulfonate |
| | 5 grams | Disodium beta-glycero phosphate |
| | 5 grams | $Na_2HPO_4$ |
| | 1 gram | Triton 405 (sufactant) |
| | 100 grams | Water |

In connection with the teaching of the PCT application, it is noted that the developing solutions described therein use low molecular weight film formers such as sodium glycero phosphate. The basic requirements for these developers in the present application, however, do not necessitate such a restriction. Thus, high concentration (10—50%) of hydrotropic materials such as sodium xylene sulfonate, potassium toluene sulfonate, potassium cumene sulfonate and the like, in combination with alkaline salts in a weight concentration of from 1—15% may be used. Alkaline salts especially useful in this context are disodium phosphate, trisodium phosphate, sodium tripoly phosphate, tetrapotassium pyro phosphate, sodium hexametaphosphate, sodium glycerophosphate and the like. Other useful alkaline salts include sodium metasilicate, sodium orthosilicate, water glass and other complex sodium silicates, sodium citrate, potassium gluconate, sodium carbonate, ammonium metavanadate, potassium hydroxide, sodium acetate and the like. Of course, nonionic and anionic surfactants and combinations thereof may also be added as may film formers, thickeners, buffering agents, builders, defoamers and so on.

Example 20

In addition to the film and paper substrate products of the prior examples, the photosensitive recording materials according to the present invention include lithographic plates having as substrates the rigid materials commonly employed in that field. With lithographic plates, the developing formulations of Example 19 are particularly useful since they make possible one chemical, one step development and gumming. Of course, with lithographic printing plates, it is not necessary to use coloring media in the image layer although coloring media may optionally be introduced into the image layer in order to enhance visibility of the lithographic image.

One useful lithographic article may be made as follows. A grained silicated aluminum substrate is coated with both image and resist compositions comprising:

1. Image layer:

| | |
|---|---|
| 60 grams | Phthalocyanine blue |
| 210 grams | SMA (molecular weight 20,000) |
| 1,000 grams | Ethylene glycol mono methyl ether |

Resist layer:

| | |
|---|---|
| 100 grams | Diazo ZAL.BF4 |
| 30 grams | Epoxy resin (Araldite 7073 from Ciba-Geigy—Araldite is a Trade Mark) |
| 30 grams | Novalak 1280 (from Union Carbide) |
| 800 grams | Dimethyl formamide |
| 200 grams | MEK |

Each layer is about 1 μm in thickness. Exposure is carried out with an ultraviolet radiation source through a negative mask. The lithographic plate thus produced is developed and gummed with composition 6 of Example 19. The resulting product is run on an offset press for several thousand copies which are all of acceptable definition and quality. Furthermore, these plates are resistant to the typical acidic fountain solutions used in printing operations. Uniquely, these plates are dot etchable, therefore, correctable after exposure.

Further lithographic plates are produced using the same grained silicated aluminum substrate with the following image layers and resist layers:

2. Image layer:

| | |
|---|---|
| 100 grams | SMA (molecular weight 50,000) |
| 20 grams | SMA (molecular weight 10,000) |

Resist layer:

| | |
|---|---|
| 100 grams | Diazo BBP |
| 10 grams | Butvar B76 (from Monsanto) |
| 50 grams | Phenolic resin (Vinsol 790224-B) from Hercules) |
| 2 grams | Methylene blue dye |

3. Image layer:

| | |
|---|---|
| 100 grams | SMA (molecular weight 20,000) |
| 20 grams | SMA (molecular weight 2,000) |
| 30 grams | Dinitraniline orange |

Resist layer:

| | |
|---|---|
| 100 grams | Diazo BBP |
| 50 grams | Acrylic resin (DuPont 2044) |
| 10 grams | Styrene allyl alcohol resin (Monsanto RJ101) |
| 400 grams | Dimethyl acetamide |
| 400 grams | Ethylene glycol mono methyl ether |

4. Image layer:

| | |
|---|---|
| 100 grams | SMA (molecular weight 20,000) |
| 900 grams | n-butyl alcohol |

Resist layer:

| | |
|---|---|
| 80 grams | Diazo ZAL.BF4 |
| 20 grams | SMA (molecular weight 50,000) |
| 30 grams | SMA (molecular weight 10,000) |
| 20 grams | Lithol rubine |
| 900 grams | Dimethyl acetamide |

As in the case of formulation 1 of this example, each of the above formulations is exposed and developed by one of the developers of Example 19 to produce negative working plates. Naturally, the use of the positive working resist layers of Example 14 would give the positive analogue of these plates.

The spatial separation of the image coat from the photosensitive materials of the resist coat makes for the production of a more readily manufactured lithographic plate than would be the case with single layer plates. Furthermore, by making the bottom layer ultraviolet light absorptive, it is found that superb antihalation properties can be obtained which are not found in single layer plates.

Example 21

This example illustrates the outstanding dot etchability characteristics of the present photosensitive recording materials. A half-tone print is made conventionally to produce a bi-layer image with an array of dots in highlight areas and an array of holes in shadow areas. A similar half-tone image is produced with a commercially available silver halide based film for comparison purposes.

The respective dots and holes of these images are examined under 200× magnification and then subjected to etching.

Typical of the etch changes obtained with the bi-layer film were the following:

| Original half-tone image area (% of entire film) | Etched image area (% of entire film) | Percent change |
|---|---|---|
| 90 (shadow) | 65 | 27 |
| 60 (mid-range) | 25 | 58 |
| 40 (mid-range) | 10 | 75 |
| 15 (highlight) | 5 | 67 |

Etching was accomplished in each of the above cases without a significant change in through-dot density. The original density prior to etching was about 3.6—3.8. Dot density remained in the 3.6—3.8 range after etching.

With the silver halide based films, however, it was found that on etching change of 10—20% in a mid-range, half-tone image (40—60% of surface area) was the maximum etch attain-without significant reduction in through-dot density. Highlight dots (5—20% of surface area) for silver based film were even less amenable to etching before unacceptable density losses occurred. Indeed, with the silver halide base films the density upon etching was found to be reduced from an original density of 4.5 to 2.6 or less. Such a density change, either locally or across the film, narrows the acceptable window for exposure and, indeed, may render the film useless as a mask to ultraviolet light.

**Claims**

1. A photosensitive recording material which comprises a substrate having thereon, in the order specified, an image layer of thickness 0.3 to 3.0 micrometres and a photosensitive resist layer of thickness 0.5 to 2.0 micrometres, the image layer comprising a copolymer of molecular weight of 1000 to 150000 of the following formula:

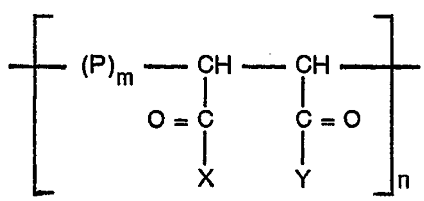

in which P is units of styrene, ethylene or methyl vinyl ether, X is —OH, —$ONH_4$, —ONa, —OK, —OLi, —OR, —$ONH_3R$, —$ONH_2R_2$, —$ONHR_3$, or —$ONH_3RNH_2$, in which R is an optionally substituted alkyl group, Y is any group that X may be, or X and Y together represent —O—, m is 1 to 13 and n is 1 to 10.

2. A recording material according to claim 1, in which the image layer contains a colorant.

3. A photosensitive recording material which comprises a substrate having thereon, in the order specified, an image layer of thickness 0.3 to 3.0 micrometres comprising a film-forming vehicle and a colorant uniformly dispersed therein in an amount sufficient to provide an optical density of at least 3.0, and a photosensitive resist layer of thickness 0.5 to 2.0 micrometres.

4. A photosensitive recording material according to claim 3, in which the film-forming vehicle comprises bimodal styrene-maleic anhydride copolymer comprising 0.25 to 4 parts by weight, preferably 2/3 to 1½ parts by weight, of a copolymer of an average molecular weight greater than 10,000 and one part by weight of a copolymer of an average molecular weight of less than 5,000.

5. A recording material according to any of claims 2 to 4, in which the ratio of colorant, film-forming vehicle is less than 1:1.

6. A recording material according to any of claims 1 to 5, in which the resist layer comprises a minor amount of a discontinuous phase, the continuous phase being a photosensitive material, the solubility of which with respect to developer changes on exposure to actinic radiation, and the discontinuous phase being a polymeric emulsion-dispersion comprising a particulate material which is substantially insoluble in said developer, the photosensitive material being a diazo composition, a light-sensitive dye, a dichromate, an azo compound, a photopolymer or a silver halide/gelatin emulsion and the polymeric emulsion containing an acrylic polymer, an ethylene-vinyl acetate copolymer, a styrene-acrylate copolymer, polyvinyl acetate or a vinyl acetate-acrylate copolymer.

7. A recording material according to claim 6, in which the diazo composition is a condensation product of a carbonyl compound and 4-diazo-1,1'-diphenylamine, a diazo colloid mixture or a developer-soluble diazo compound.

8. A recording material according to any of claims 1 to 7, which further comprises a subbing layer between the image layer and the substrate for preventing staining of the substrate and improving adhesion between the substrate and the image layer, the subbing layer having a thickness of up to 2 micrometres and comprising a styrene-maleic anhydride copolymer of molecular weight greater than 10000.

9. A method of halftone etching, which comprises producing a halftone image on a recording material, and treating said halftone image with a developer to selectively remove portions of the perimeters of the image layer without significantly altering the thickness or density of said image layer, characterised in that the recording material is as claimed in any of claims 1 to 8.

**Patentansprüche**

1. Lichtempfindliches Aufzeichnungsmaterial, umfassend ein Substrat, auf dem, in der angegebenen Reihenfolge, eine Bildschicht einer Dicke von 0,3 bis 3,0 µm und eine Lichtempfindliche Resistschicht eine Dicke von 0,5 bis 2,0 µm aufgebracht ist, wobei die Bildschicht ein Copolymer mit einem Molekulargewicht von 1 000 bis 150 000 der folgenden Formel

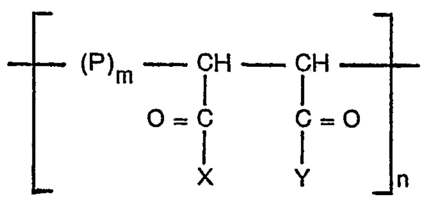

umfaßt, worin P Styrol-, Ethylen- oder Methylvinylethereinheiten betdeutet, X —OH, —ONH$_4$, —ONa, —OK, —OLi, —OR, —ONH$_3$R, —ONH$_2$R$_2$, —ONHR$_3$ oder —ONH$_3$RNH$_2$ ist, worin R eine gegebenenfalls substituierte Alkyl-gruppe bedeutet, Y die Bedeutung von X hat oder X und Y zusammen —O— bedeuten, m 1 bis 13 und n 1 bis 10 ist.

2. Aufzeichnungsmaterial nach Anspruch 1, worin die Bildschicht ein Farbungsmittel enthält.

3. Lichtempfindliches Aufzeichnungsmaterial, umfassend ein Substrat, aur dem, in der angegebenen Reihenfolge, eine Bildschicht einer Dicke von 0,3 bis 3,0 µm, umfassend ein filmbildendes Vehikel und ein gleichmäßig darin dispergiertes Färbungsmittel in einer Menge, die ausreichend ist, um eine optische Dichte von wenigstens 3,0 zu ergeben, und eine lichtempfindliche Resistschicht einer Dicke von 0,5 bis 2,0 µm aufgebracht ist.

4. Lichtempfindliches Aufzeichnungsmaterial nach Anspruch 3, worin das filmbildende Vehikel ein bimodales Styrol-Maleinsäureanhydrid-Copolymer umfaßt, welches 0,25 bis 4 Gewichtsteile, vorzugsweise 2/3 bis 1 1/2 Gewichtsteile, eines Copolymers mit einem mittleren Molekulargewicht von mehr als 10 000 und 1 Gewichtsteil eines Copolymers mit einem mittleren Molekulargewicht von weniger als 5 000 umfaßt.

5. Aufzeichnungsmaterial nach einem der Ansprüche 2 bis 4, worin das Verhältnis des Färbungsmittels zu dem filmbildenden Vehikel weniger als 1:1 beträgt.

6. Aufzeichnungsmaterial nach einem der Ansprüche 1 bis 5, worin die Resistschicht eine geringe Menge einer diskontinuierlichen Phase umfaßt, wobei die kontinuierliche Phase ein lichtempfindliches Material ist, dessen Löslichkeit sich in Bezug auf den Entwickler beim Belichten mit aktinischer Strahlung ändert, und die diskontinuierliche Phase eine Polymeremulsionsdispersion ist, die ein Partikelmaterial, das weitgehend unlöslich in dem Entwickler ist, umfaßt, und das lichtempfindliche Material eine Diazozusammensetzung, ein lichtempfindlicher Farbstoff, ein Dichromat, eine Azoverbindung, ein Photopolymer oder eine Silberhalogenid/Gelatineemulsion ist und die Polymeremulsion ein Acrylpolymer, ein Ethylen-Vinylacetat-Copolymer, ein Styrol-Acrylat-Copolymer, Polyvinylacetat oder ein Vinylacetat-Acrylat-Copolymer enthält.

7. Aufzeichnungsmaterial nach Anspruch 6, worin die Diazozusammensetzung ein Kondensationsprodukt einer Carbonylverbindung und 4-Diazo-1,1'-diphenylamin, eine Diazokolloidmischung oder eine entwicklerlösliche Diazoverbindung ist.

8. Aufzeichnungsmaterial nach einem der Ansprüche 1 bis 7, welches weiterhin eine Unter- bzw. Substratschicht zwischen der Bildschicht und dem Substrat umfaßt, um eine Färbung des Substrats zu verhindern und die Adhäsion zwischen dem Substrat und der Bildschicht zu verbessern, wobei die Unter- bzw. Substratschicht eine Dicke von bis zu 2 µm besitzt und ein Styrol-Maleinsäureanhydrid-Copolymer mit einem Molekulargewicht von mehr als 10 000 umfaßt.

9. Verfahren zum Halbtonätzen, das die Herstellung eines Halbtonbildes auf einem Aufzeichnungsmaterial und die Behandlung des Halbtonbildes mit einem Entwickler umfaßt, um selektiv Teile der Perimeter der Bildschicht zu entfernen, ohne die Dicke oder Dichte der Bildschicht beträchtlich zu ändern, dadurch gekennzeichnet, daß das Aufzeichnungsmaterial das Aufzeichnungsmaterial nach einem der Ansprüche 1 bis 8 ist.

**Revendications**

1. Matériau photosensible d'enregistrement qui comprend un substrat portant, dans l'ordre spécifié, une couche de formation d'image ayant une épaisseur de 0,3 à 3,0 microns et une couche de réserve photosensible de 0,5 à 2,0 microns d'épaisseur, la couche d'image comprenant un copolymère de poids moléculaire compris entre 1000 et 150 000 et de formule suivante:

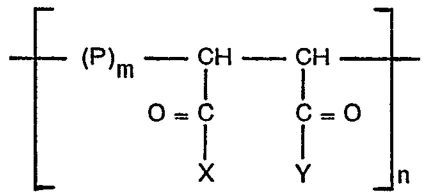

dans laquelle P désigne des motifs styrène, éthylène ou méthylvinyléther, X est —OH, $—ONH_4$, —ONa, —OK, —OLi, —OR, $—ONH_3R$, $—ONH_2R_2$, $—ONHR_3$, ou $—ONH_3RNH_2$, R étant un groupe alkyle éventuellement substitué, Y est un groupe quelconque que peut être X, ou X et Y représentent ensemble —O—, m est compris entre 1 et 13 et n est compris entre 1 et 10.

2. Matériau d'enregistrement selon la revendication 1, dans lequel la couche d'image contient une matière colorante.

3. Matériau photosensible d'enregistrement, qui comprend un substrat portant, dans l'ordre spécifié, une couche de formation d'image d'épaisseur comprise entre 0,3 et 3,0 microns, comprenant un véhicule filmogène et une matière colorante uniformément dispersée à l'intérieur en quantité suffisante pour que la densité optique soit au moins égale à 3,0, et une couche de réserve photosensible dont l'épaisseur est comprise entre 0,5 et 2,0 microns.

4. Matériau photosensible d'enregistrement selon la revendication 3, dans lequel le véhicule filmogène comprend un copolymère bimodal de styrène-anhydride maléique contenant 0,25 à 4 parties en poids et de préférence 2/3 à 1,5 parties en poids d'un copolymère de poids moléculaire moyen supérieur à 10 000 et une partie en poids d'un copolymère de poids moléculaire moyen inférieur à 5000.

5. Matériau d'enregistrement selon l'une quelconque des revendications 2 à 4, dans lequel le rapport de la matière colorante au véhicule filmogène est inférieur à 1/1.

6. Matériau d'enregistrement selon l'une quelconque des revendications 1 à 5, dans lequel la couche de réserve prend une petite quantité d'une phase discontinue, la phase continue étant un matériau photosensible dont la solubilité dans le révélateur change lors de l'exposition à une rayonnement actinique, et la phase discontinue étant une émulsion-dispersion polymère comprenant une matière polymère qui est pratiquement insoluble dans le révélateur, la matière photosensible étant une composition diazoïque, un colorant photosensible, un bichromate, un colorant azoïque, un photopolymère ou une émulsion d'halogénures d'argent et de gélatine et l'émulsion polymère contenant un polymère acrylique, un copolymère d'éthylène-acétate de vinyle, un copolymère styrène-acrylate, de l'acétate de polyvinyle ou un copolymère acétate de vinyle-acrylate.

7. Matériau d'enregistrement selon la revendication 6, dans lequel la composition diazoïque est un produit de condensation d'un composé carbonylé et de 4-diazo-1,1'-diphénylamine, un mélange de colloïde diazoïque ou un composé diazoïque soluble dans le révélateur.

8. Matériau d'enregistrement selon l'une quelconque des revendications 1 à 7, qui comporte en outre une couche intermédiaire entre la couche d'image et le substrat, destinée à empêcher le maculage du substrat et améliorant l'adhérence entre le substrat et la couche d'image, la couche intermédiaire ayant une épaisseur pouvant atteindre 2 microns et comprenant un copolymère styrène-anhydride maléique de poids moléculaire supérieur à 10 000.

9. Procédé d'attaque chimique en demi-teinte, qui comprend la formation d'une image en demi-teinte sur un matériau d'enregistrement, et le traitement de l'image en demi-teinte par un révélateur afin que des parties des périmètres de la couche d'image soient retirées sélectivement sans modification importante de l'épaisseur ou de la densité de la couche d'image, caractérisé en ce que le matériau d'enregistrement est tel que revendiqué dans l'une quelconque des revendications 1 à 8.

Fig-1-

ACTINIC RADIATION

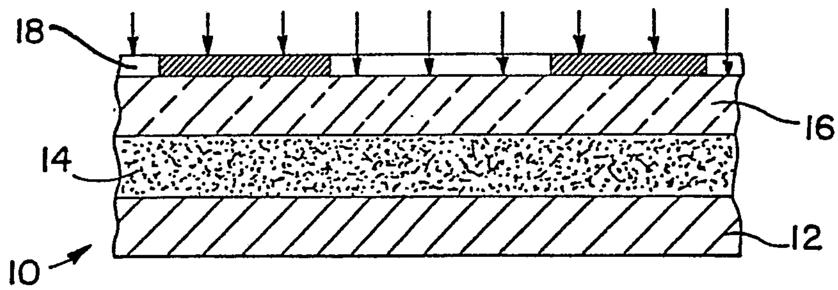


Fig-2-

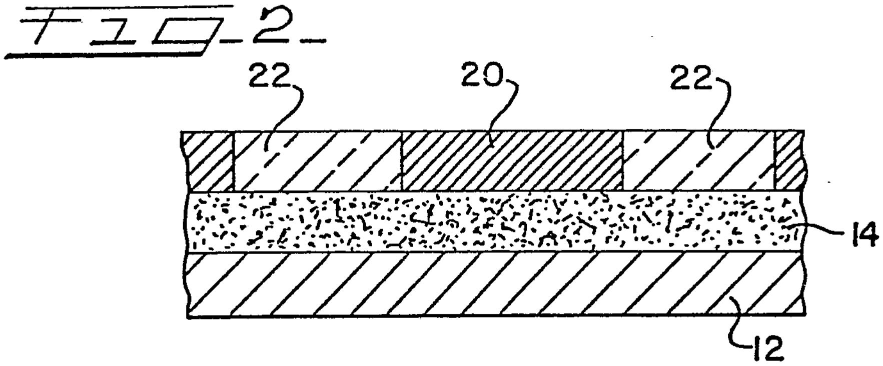


Fig-3-

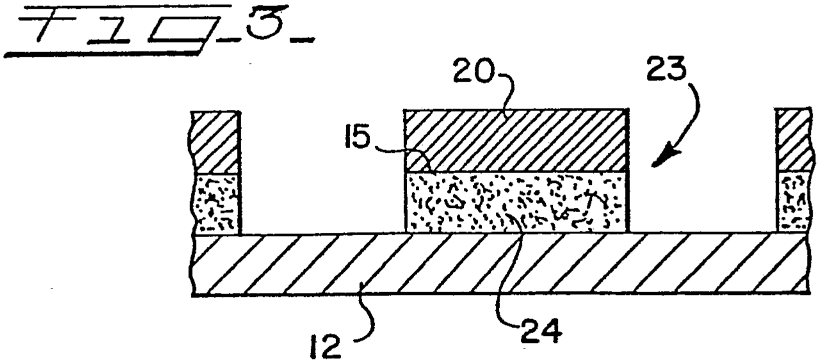

Fig-4-

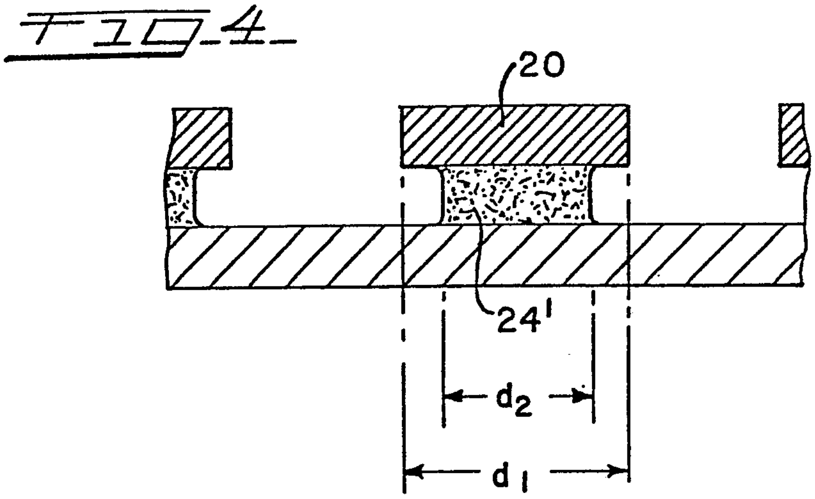


Fig-5-

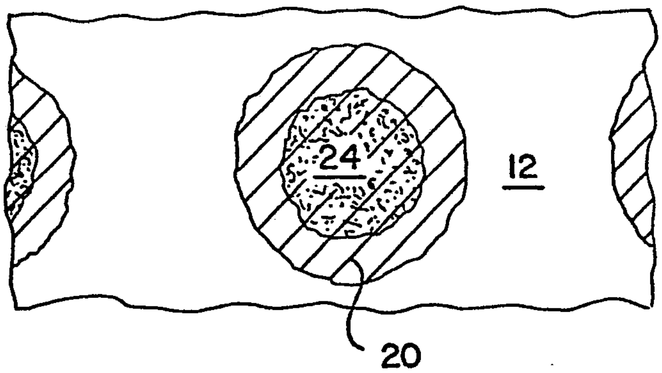


Fig-6-